# EUROPEAN PATENT SPECIFICATION

(11) **EP 3 945 762 B1**
(45) Date of publication and mention of the grant of the patent: **28.01.2026**
(21) Application number: 21188705.4
(22) Date of filing: 30.07.2021
(51) Int. Cl.: H05K 7/20, H01L 23/473, H02J 3/18

(54) **SCALABLE MODULAR COOLING UNIT HAVING VOLTAGE ISOLATION**
SKALIERBARE MODULARE KÜHLEINHEIT MIT SPANNUNGSISOLIERUNG
UNITÉ DE REFROIDISSEMENT MODULAIRE ÉVOLUTIVE DOTÉE D'UNE ISOLATION DE LA TENSION

(30) Priority: 31.07.2020 US 202062706112 P; 14.07.2021 US 202117375919
(43) Date of publication of application: 02.02.2022
(73) Proprietor: Smart Wires Inc., Durham, NC 27703 (US)
(72) Inventor: Inam, Haroon, San Jose (US); Farahani, Ali, Yorba Linda (US)
(74) Representative: Gallego Jiménez, José Fernando

(56) References cited:
- KR-A- 20190 097 469
- US-A1- 2013 026 841
- US-A1- 2017 055 378

## Description

### Technical field

Embodiments of the disclosure relate to liquid-cooled flexible AC transmission systems (FACTS), with voltage isolation enabling series connected impedance injection modules.

### Background

Modern-day distributed power generation and distribution systems have introduced multi-generator grids and new modes of operation. These new modes of operation may introduce power electronic (PE) converters, such as power flow control systems used to inject reactive impedance or reactive power into transmission lines. These systems generally include high current devices that generate high thermal loads. To date, power flow control systems have typically used air cooling for heat dissipation. There is a need in the art for liquid cooling configurations adapted for use in power flow control systems.

Document KR 2019 0097469 A discloses a temperature control device of a power compensation apparatus comprising a plurality of sub-modules connected in series, a temperature sensor measuring the temperature of the sub-modules, a cooling module cooling the sub-modules, and a control unit driving the cooling module to cool the sub-modules based on the temperature measured from the temperature sensor.

### Summary

The invention relates to a liquid cooling system, a power flow control system, and related method for liquid cooling in a power flow control system are described herein.

A first aspect of the invention is a liquid cooled power flow control system. The system may be configured to be connectable to a power transmission line. The system has an enclosure and at least one subsystem comprising a liquid cooling block, a pump, and at least one switching assembly. The liquid cooling block has an input port (also known as inlet port) and an output port (also known as outlet port). The pump may be configured for circulating liquid coolant from the inlet port to the outlet port of the liquid cooling block. The at least one switching assembly is configured to provide power flow control. The at least one switching assembly may be configured as an impedance injection unit configured for injecting reactive power into a power transmission line for providing control of the power flow. In case of having a plurality of switching assemblies, each switching assembly may be configured as an impedance injection unit. In some embodiments, at least two switching assemblies may be combined to form a single impedance injection unit. The switching assemblies are contained within the enclosure, and are electrically isolated from the enclosure. Each switching assembly may have a respective baseplate arranged to thermally couple to the liquid coolant. Each switching assembly may comprise a plurality of switches (e.g. transistors, such as IGBT transistors). The switches of each switching assembly may be part of at least one switching device integrated in the respective switching assembly. Each switching device may comprise at least one switch and, optionally, further electronic elements, such as diodes.

A second aspect of the invention is a method for liquid cooling in a power flow control system. The method includes circulating liquid coolant through a liquid cooling block. The liquid coolant is circulated to each of the switching assemblies. Each switching assembly has a baseplate. The liquid coolant is circulated using a pump. The method includes electrically isolating each of the switching assemblies from the enclosure of the liquid cooled power flow control system.

Other aspects and advantages of the invention will become apparent from the following detailed description taken in conjunction with the accompanying drawings which illustrate, by way of example, the principles of the described embodiments.

### Brief description of the drawings

The described embodiments and the advantages thereof may best be understood by reference to the following description taken in conjunction with the accompanying drawings. These drawings in no way limit any changes in form and detail that may be made to the described embodiments by one skilled in the art without departing from the scope of the described embodiments.
Figure 1 is a schematic drawing of an impedance injection unit and a bypass unit connected into a power transmission line according to one embodiment.
Figure 2 is a perspective view of an impedance injection unit separated from an enclosure according to one embodiment.
Figure 3 is a perspective internal view of an impedance injection unit showing liquid cooling blocks according to one embodiment.
Figure 4 is a schematic view of a liquid cooling block showing parallel flow of the liquid coolant according to one embodiment.
Figure 5 is a cross-sectional view of a suitable thermal structure for coupling a cooling plate to a high-power switching device contained within a high-power switching assembly according to one embodiment.
Figure 6 illustrates an enclosed liquid cooled power flow control system according to one embodiment.
Figure 7 is a schematic showing voltage isolation between high-power switching assemblies and an enclosure of a liquid cooled power flow control system according to one embodiment.

### Detailed description

A modular liquid cooling block (LCB) is described for cooling high current switching devices deployed in power flow control systems, wherein said switching devices may be formed by at least one switching assembly. Liquid coolant may be jetted directly onto a base plate of a switching assembly (thus the liquid coolant being thermally coupled to the base plate by direct impingement) or it may impinge indirectly on a cooling plate that is thermally coupled to the base plate (thus the liquid coolant being thermally coupled to the base plate by indirect impingement). The switches of the at least one switching assembly may be configured as IGBT transistors. Indirect impingement may comprise at least one jet of coolant impinging on the cooling plate, or a parallel flow of coolant past the cooling plate. Voltage isolation of switching modules (i.e. switching assemblies) is provided within each LCB and between LCBs, enabling many different series and parallel switching topologies. Problematic ionization of the liquid coolant may occur at electric fields exceeding around 1500V DC potential between switching modules. To avoid such ionization the switching modules are spaced apart and insulating materials are used.

In a first aspect of the present disclosure, a liquid cooled system may include, within an enclosure, at least one subsystem comprising a liquid cooling block (LCB) with input and output ports. The at least one subsystem may further comprise a pump configured to circulate liquid coolant in the LCB, preferably from the input port to the output port, as part of a closed-circuit fluid assembly that also may include a radiator for transferring heat to an air ambient. The subsystem may further comprise at least one switching assembly, isolated from the enclosure and connectable in series or in parallel to at least one other switching assembly, thermally coupled to the LCB through a respective baseplate arranged in the respective switching assembly. At least one switching assembly comprising a base plate may further comprise a respective cooling plate being thermally coupled to the respective base plate. Liquid coolant may impinge directly on the baseplate or indirectly onto a cooling plate thermally coupled to the baseplate. Each switching assembly may be configured to produce a DC output, for example, between 500V and 3,000V for injecting reactive power into a power transmission line. Each switching assembly may include a half bridge or a full bridge. Each series and parallel combination of switching assemblies may correspond to a different converter topology for injecting reactive power. Each series and parallel combination of switching assemblies may be configured as a respective impedance injection unit for injecting reactive power or reactive impedance into a power transmission line.

The liquid coolant may comprise mixtures of water and ethylene glycol or polyethylene glycol, although any liquid coolant may be used. If water is used it may be distilled water or de-ionized water.

In a second aspect of the present disclosure, the liquid cooled system may further comprise at least one capacitor, preferably being configured as a DC capacitor, compatible and connectable with at least one of the switching assemblies of the at least one subsystem. The at least one DC capacitor may be formed by a respective bank of capacitors connected in parallel. A respective DC capacitor may be electrically connected to at least one switching assemblies thermally coupled to an LCB. At least one of the switching assemblies of the system may be connected to a respective DC capacitor. Each switching assembly connected to a DC capacitor may be integrated into a respective power flow control module. A power flow control module may comprise a switching assembly connected to a DC capacitor, although it may further comprise additional elements. A power flow control module may be configured for injecting reactive power or reactive impedance into a transmission line, thus providing power flow control capability. The combination of capacitors with respective switching assemblies is a technical feature that is compatible with all the embodiments of the invention. Liquid coolant circulates in the LCB. Each switching assembly is electrically isolated from the enclosure with an electrical isolation of at least 4,000 V, and preferably of at least 6,000V, as an example. At least one of the power flow control modules may be configured as an impedance injection unit to inject reactive impedance, preferably of at least 1 milli-ohm (mΩ), into a power transmission line. The power flow control module may employ replaceable components, have an operational lifetime of at least 20 years and operate in ambient temperatures, for example, from -40°C to 50°C. In some embodiments, less than 10 liters of liquid coolant may be used and may be replaceable. The pressure may not exceed 2 bar.

According to a further aspect of the present disclosure, the liquid cooling power flow control system may comprise an enclosure and at least one subsystem comprising multiple power flow control modules, wherein each power flow control module comprises at least one switching assembly coupled to a bank of capacitors forming a DC capacitor, and an LCB in which liquid coolant circulates. At least one of the multiple (plurality of) switching assemblies, preferably a high-power switching assembly, is thermally coupled to the LCB and electrically coupled to the DC capacitor while being electrically isolated from the enclosure. The power flow control system may be configurable to inject reactive power of at least 10 MVA, for example, into a power transmission line. A bypass circuit configured to carry excess current may be connected in parallel with the power flow control system. The bypass circuit may include a vacuum switched link and a bank of silicon-controlled rectifiers connected in parallel. A mechanical switch may be used. Each of the power flow control modules is electrically isolated from the enclosure and may be connected in series or in parallel with other power flow control modules.

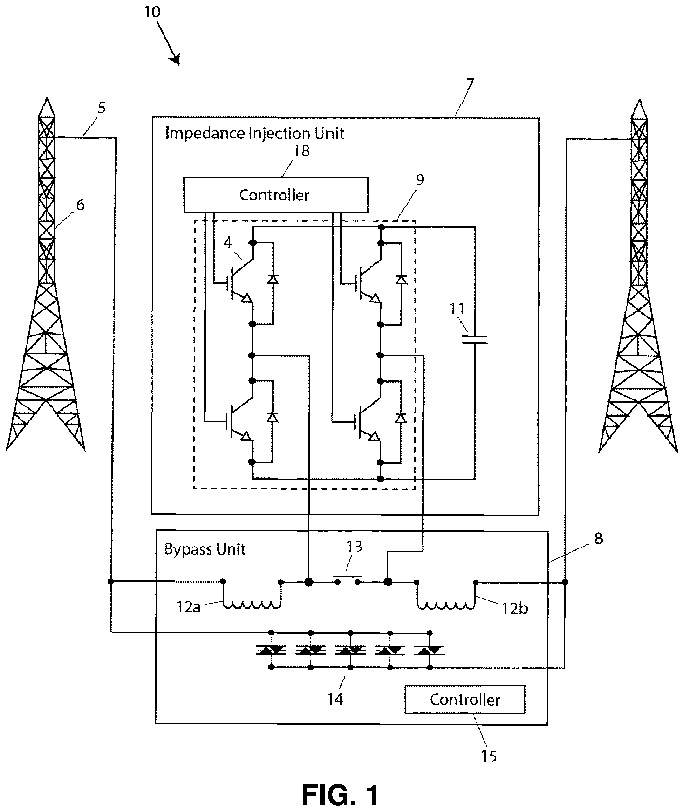

Figure 1 illustrates a power flow control system 10, series connected into a power transmission line 5 supported by a transmission line tower 6. A power transmission line 5 may comprise a high-voltage transmission line (e.g. as high as 500kV), a medium-voltage transmission line (e.g. 230kV) or a distribution line (e.g. 13 kV). It may reside inside or outside of a switching station. Power flow control system 10 includes an impedance injection unit 7 and a bypass unit 8. Impedance injection unit 7 may include a switching assembly 9 (preferably a high-power switching assembly) comprising a plurality of switching devices 4 (preferably high-power switching devices), configured to inject reactive power into power transmission line 5 by charging and discharging a DC capacitor 11 connected to the switching assembly 9. Each switching device may comprise a switch (e.g. a transistor) and optionally further electronic elements (e.g. a diode). Switching assembly 9 may include a full bridge configuration as shown, or a half bridge configuration. Bypass unit 8 includes differential mode chokes (DMCs) 12a, 12b, a vacuum switched link 13, a bank 14 of silicon-controlled rectifiers (SCRs), and a bypass controller 15. The bypass unit 8 may include a bypass path comprising a mechanical switch.

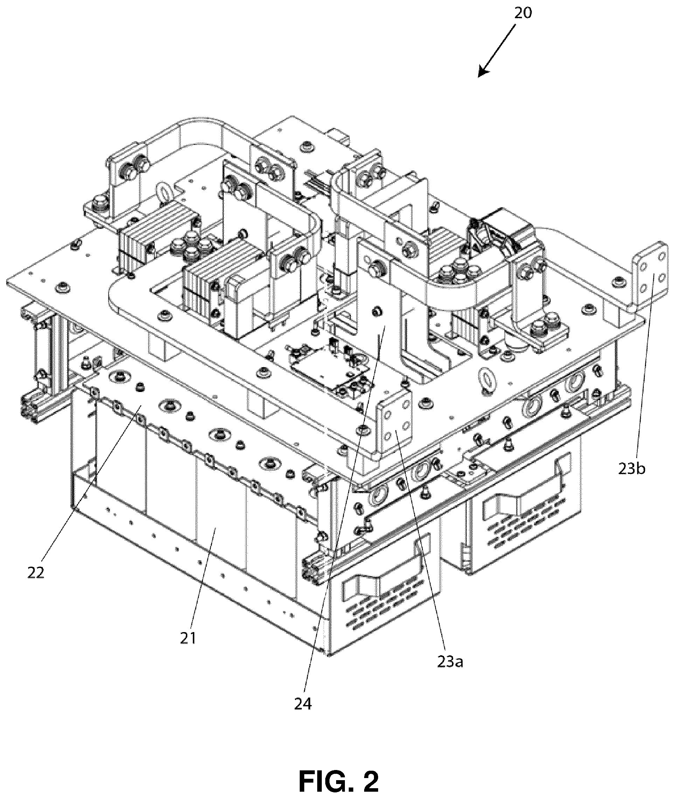

Figure 2 is a perspective view of an impedance injection unit 20 separated from an enclosure according to one embodiment. In Figure 2, an impedance injection unit 20 (also referred to as power flow control unit or power control module) is configured to inject reactive power (e.g., 1 Mega Volt Amp (MVA)) into a power transmission line 5. Impedance injection unit 20 includes multiple switching assemblies 9 (preferably a high-power switching assembly) described in reference to Figure 1. A capacitor 21 is shown, one of a bank of capacitors implementing DC capacitor 11, connected to DC bus 22. Terminals 23a and 23b denote connection points of an AC bus 24 to the power transmission line 5. The components of impedance injection unit 20 may be replaceable and may have an operating lifetime greater than 20 years for example.

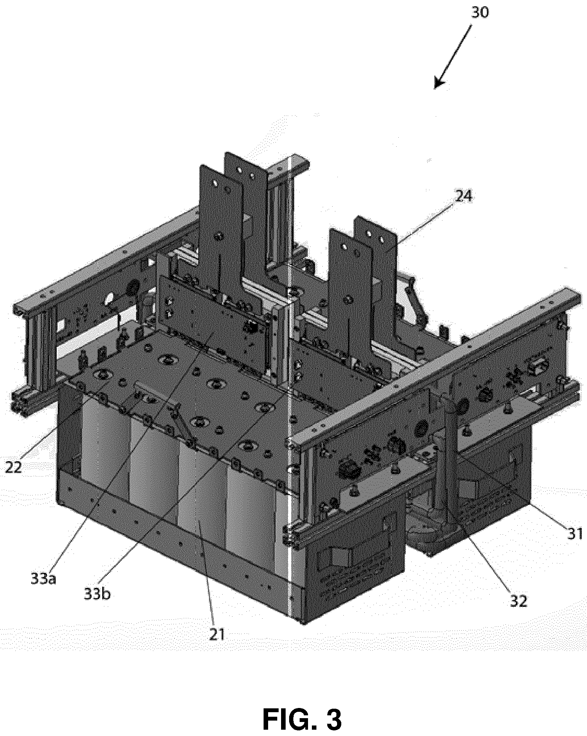

Figure 3 shows a partially disassembled impedance injection unit 30. In some embodiments, impedance injection unit 30 is impedance injection unit 20 of Figure 2. Referring to Figure 3, inlet pipe 31 of the input port and outlet pipe 32 of the output port carry liquid coolant to LCBs that are hidden behind printed circuit boards 33a and 33b, with each circuit board 33a and 33b hosting control circuits for a switching assembly (preferably a high-power switching assembly) associated with the corresponding LCB. DC capacitor 21 and DC bus 22 are also shown.

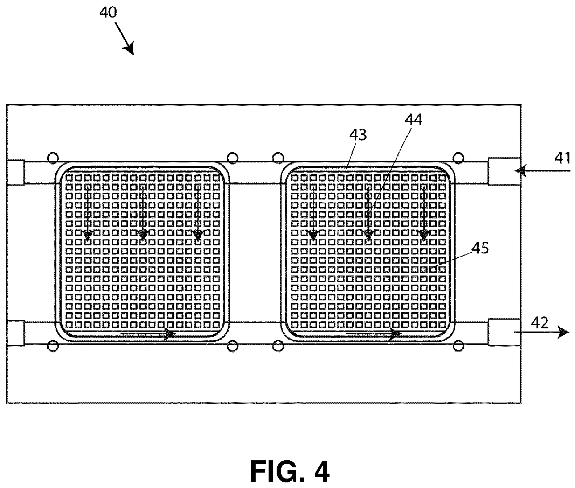

Figure 4 depicts parallel flow of liquid coolant in an LCB. An inlet port 41 (connecting to inlet pipe 31 of figure 3) and outlet port 42 (connecting to outlet pipe 32 of Figure 3) are shown. Coolant is released through an aperture configured as a slot 43 in a parallel flow arrangement indicated by arrows 44 and located in the input port 41. The slot 43 may be preferably configured to have the same length as the base plate and/or of the cooling plate of the respective switching assembly. Although in Figure 4 the coolant is released through an aperture configured as a single slot 43, in other embodiments of the invention the liquid coolant may be released through other configurations comprising one or more jetting aperture arranged in the same conduit as the inlet port 41. The coolant is released through the respective aperture to impinge on a base plate or on a cooling plate that may have three-dimensional surface features 45; three-dimensional surface features 45 (which may be optional in some embodiments) increase the contact area of coolant and thereby increase heat transfer from liquid coolant to the respective plate. Three-dimensional surface features 45 may comprise raised areas having square or trapezoidal shapes for example. The liquid coolant may be a combination of one or more of distilled water, de-ionized water, ethylene glycol, and polyethylene glycol for example, although any suitable liquid coolant may be used. The liquid coolant may have an operating pressure (less than 2 bar for example) and may be compatible with an operating temperature (e.g., -40°C to 50°C) for the associated impedance injection module. The amount of liquid coolant required for an impedance injection unit 20 may be less than 10 liters for example but may be more or less in other embodiments. The liquid coolant may be replaceable or may be contained in a sealed manner that does not require replacement.

Liquid cooling blocks of the present disclosure may be configured to provide individualized flow channels having respective apertures to provide direct impingement, indirect impingement, and parallel flow. For direct impingement, the at least one aperture is configured to provide a least one jet of cooling fluid (i.e. liquid coolant) that impinges directly on a cooling plate. For indirect impingement, the at least one aperture is configured to provide at least one jet of cooling fluid (i.e. liquid coolant) that impinges on a metal wall of the LCB that is thermally coupled to a cooling plate and/or to base plate. For parallel flow, the coolant fluid exits from a slot rather than a jetting aperture and passes with parallel flow over an internal wall coupled to a cooling plate or directly over a cooling plate. In each case the cooling plate is thermally coupled to an electronic module with a low thermal resistance between them.

Problematic ionization of the liquid coolant may occur at electric fields produced by a potential (e.g., around 1500 VDC) between switching modules (i.e. the switching assemblies). To avoid such ionization the switching modules (i.e. the switching assemblies) are spaced apart with an adequate separation distance, and insulating materials are used. The insulating materials may include fiber reinforced plastic (FRP) or nylon for example, and the separation distance may be greater than 8mm for example.

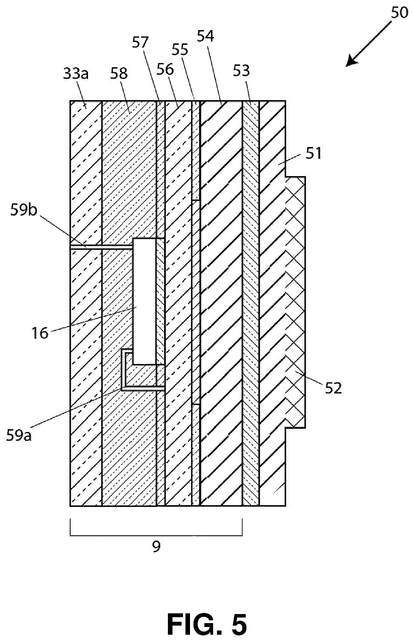

Figure 5 illustrates an example thermal construction for providing a low thermal resistance path between liquid coolant impinging on a cooling plate surface and switching devices (preferably high-power switching devices) that are part of a switching assembly 9 (preferably a high-power switching assembly). Cooling plate 51 is shown with raised surface features 52. Cooling plate 51 is coupled through a sheet 53 of thermal interface material (TIM) to a base plate 54 of a high-power switching assembly 9. Switching device 16 (preferably being configured as a high-power switching device) may be an insulated gate bipolar transistor (IGBT) for example, and may be part of a half-bridge or a full-bridge configured to charge and discharge DC capacitor 11 to achieve injection of a reactive impedance into a power transmission line 5 for example. The thermal path may include solder 55, a ceramic sheet 56 on which wire bonds 59a connecting to an active device 16 are terminated, and a second sheet 57 of thermal interface material. A potting material 58 such as silicone may be used to fill air gaps surrounding high-power switching device 16. A printed circuit board 33a is shown, providing control inputs 59b to high-power switching devices 16.

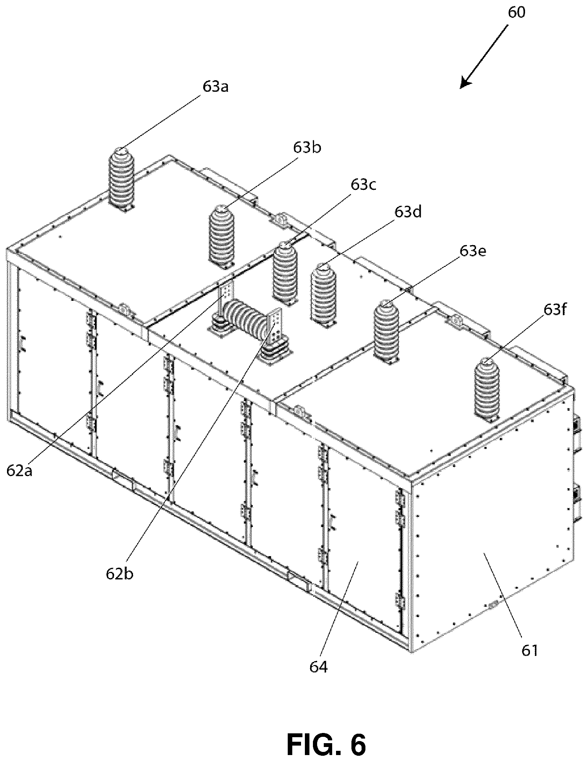

Figure 6 illustrates a liquid cooling power flow control system 60 that includes ten power flow control units 20 (although the system may comprise any plurality of power flow control units 20) described in reference to Figure 2. Power flow control system 60 is contained within an enclosure 61 and may be configured to provide reactive power (e.g., 10 MVA) for injection into a power transmission line for example. In other embodiments, higher amounts of reactive power may be achieved and/or other numbers of power flow control unit 20 may be used. Terminals 62a and 62b are shown for connecting to a power transmission line 5. The ten power flow control units 20 may be arranged in groups of two parallel connected units in each group forming a respective dual unit. Thus, five dual units are connected in series, though other combinations may be used. Parallel connected units are used to increase the level of injected current, and series units provide a desired level of injected voltage. Terminals 63a through 63f provide connection points for the dual units. A door 64 provides access for installing a dual unit or other equipment in enclosure 61.

A rail system may be used for mounting the various modules of the liquid cooling power flow control system 60, enabling convenient access for maintenance and replacement, as necessary.

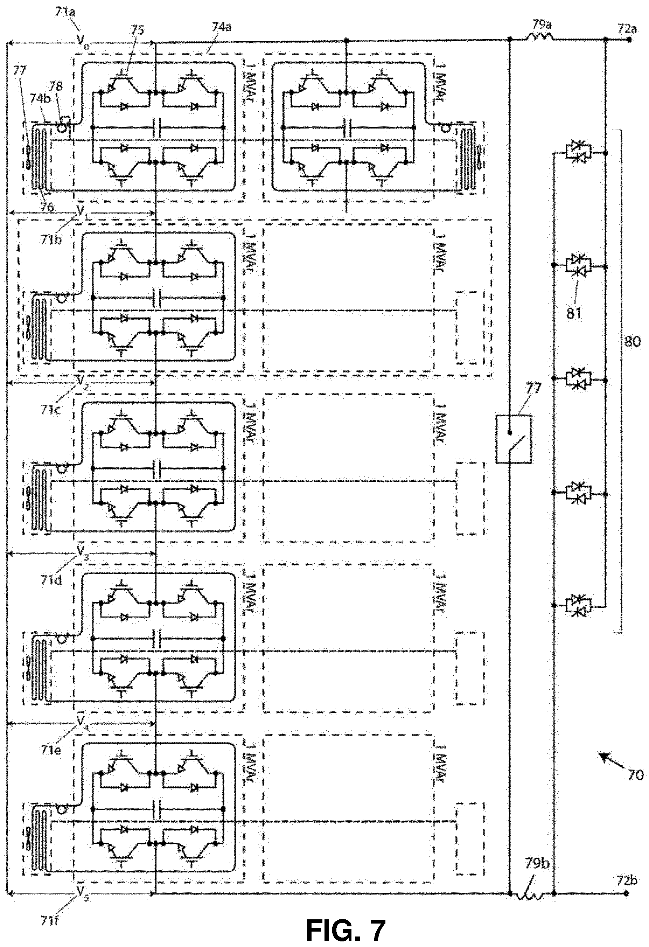

Figure 7 is a schematic 70 that illustrates a liquid cooling power flow control system 60 comprising an enclosure and a plurality of ten subsystems, wherein each subsystem respectively comprises a power flow control module 74a, a liquid cooling block and a pump 78. Each power flow control module 74a comprises a respective switching assembly connected to a DC capacitor. Figure 7 shows, in particular, that the plurality of subsystems are arranged forming pairs of subsystems, wherein the respective power flow control modules of each pair of subsystems are parallel connected to each other forming dual units, and wherein the five resulting dual units are connected in series to each other, having voltage isolation between each dual unit and the enclosure 61. The input potential at the first dual unit is shown as V0, 71a, and the output potential is shown as V1, 71b. For units in series, each voltage 71a, 71b, 71c, 71d, 71e, 71f may exceed a prior voltage level by the amount of voltage injection by each dual unit, 0.8kV for example. In this example, voltage isolation exceeding 0.8 kV is provided between each dual unit. This is necessary to enable series connection of the units required for desired levels of injection of reactive power into a power transmission line connected between nodes 72a and 72b. At node 71f, the level of voltage isolation between the 5th dual unit and the enclosure 61 is required to be greater than 5 x 0.8kV or 4.0 kV in this example.

Each subsystem is depicted as being formed by two isolated assemblies 74a and 74b. Isolated assembly 74a includes a power switching assembly 75 that may comprise a set of four insulated gate bipolar transistors (IGBTs) connected as shown for injecting power from the DC capacitor 11 (see Figure 1) onto the power transmission line 5. Each of the IGBTs depicted may comprise two or more IGBT chips connected in parallel. Isolated assembly 74b comprises thermal cooling equipment including an optional radiator 76, an optional fan 77 and a pump 78. The optional radiator 76, the optional fan 77 and the pump 78 are combinable and compatible with any switching assembly and/or with any power control module according to the invention. Each power switching assembly 75 is associated with (or connected to) an LCB, such as LCB 40 (see Figure 4). Each LCB may be configured to act in connection with any of the entities of the thermal cooling equipment. Each LCB may be integrated into the isolated assembly 74a. Isolated assemblies 74a and 74b may comprise structural members fabricated using non-electrically conductive materials such as fiber reinforced plastic (FRP). One version of FRP comprises a polyester resin and has an operating temperature, for example, up to around 140°F. Another version of FRP comprises an epoxy resin and has an operating temperature, for example, up to around 240°F. Although not required for voltage isolation, tubing for circulating the coolant may comprise a non-electrically conductive material, such as silicone. As an example, each power switching assembly 75 may be provided with an electrical isolation (e.g., at least 6,000V of electrical isolation) from enclosure 61.

Bypass circuits may also be included, such as a vacuum switched link (VSL) 77 for providing an alternate path for bypass current. Current limiting chokes 79a and 79b may be provided as shown.

A bank 80 of SCRs 81 may be provided in parallel as shown, used for bypassing high currents during fault conditions on the associated power transmission line. Each SCR 81 must be capable of withstanding the isolation voltage, such as 4.0 kV shown on node 71f.

The teachings contained in the embodiments described herein may be applied to stand-alone liquid cooled electronic modules, and to liquid cooled power flow control units and systems.

The foregoing description, for the purpose of explanation, has been described with reference to specific embodiments. However, the illustrative discussions above are not intended to be exhaustive or to limit the invention to the precise forms disclosed. Many modifications and variations are possible in view of the above teachings. The embodiments were chosen and described in order to best explain the principles of the embodiments and its practical applications, to thereby enable others skilled in the art to best utilize the embodiments and various modifications as may be suited to the particular use contemplated. Accordingly, the present embodiments are to be considered as illustrative and not restrictive, and the invention is not to be limited to the details given herein, but may be modified within the scope of the appended claims.

## Claims

1. A liquid cooling power flow control system series connectable to a power transmission line (5), the system comprising an enclosure (61) and a plurality of subsystems comprising;
a liquid cooling block (40) comprising a liquid coolant, an inlet port (41) for the liquid coolant and an outlet port (42) for the liquid coolant;
a pump (78) configured for circulating the liquid coolant through the liquid cooling block (40); and
at least one switching assembly (9, 75) connectable to a power transmission line (5) and configured to inject a reactive power or a reactive impedance into the power transmission line (5) for power flow control of the power transmission line (5);
wherein each of the at least one switching assembly is contained within and electrically isolated from the enclosure (61);
wherein each of the at least one switching assembly (9, 75) comprises a base plate (54) arranged to thermally couple to the liquid coolant of one of the at least one liquid cooling block (40);
wherein at least one switching assembly (9, 75) further comprises a cooling plate (51) that is thermally coupled to the respective base plate (54) of the respective switching assembly (9, 75);
wherein each switching assembly (9, 75) electrically isolated from the enclosure (61) is configured for withstanding an isolation voltage of at least 4000 V, preferably for withstanding an isolation voltage of at least 6000 V;
wherein at least one pair of the plurality of subsystems are connected in parallel to each other forming at least one dual unit, wherein each subsystem forming a dual unit is respectively configured as a power flow control module comprising a DC capacitor connected to the respective at least one switching assembly (9,75) of the respective subsystem;
wherein the one or more dual units are series connected to each other; and
wherein the one or more dual units are series connected to other subsystems of the plurality of subsystems.

2. The liquid cooling power flow control system of claim 1,
wherein the liquid cooling block (40) of the at least one subsystem is configured such that the liquid cooling impinges onto the respective base plate (54) of at least one switching assembly (9, 75) and/or onto the respective cooling plate (51) that is thermally coupled to a base plate (54) of at least one switching assembly (9, 75) .

3. The liquid cooling power flow control system of claims 1 or 2,
wherein each of the at least one switching assembly (9, 75) of the at least one subsystem is configurable to produce an AC output for injecting reactive power or reactive impedance into a power transmission line (5); and/or
wherein the at least one switching assembly (9, 75) of the at least one subsystem is configured as a plurality of switching assemblies (9, 75) that are connectable in series or in parallel to each other for injecting reactive power or reactive impedance into the power transmission line (5).

4. The liquid cooling power flow control system of any of the preceding claims,
wherein the cooling plate (51) of at least one switching assembly (9, 75) of the at least one subsystem has raised areas (45, 52) defining a three-dimensional surface; and/or
wherein the cooling plate (51) of at least one switching assembly (9, 75) of the at least one subsystem is thermally coupled to respective base plate (54) through thermal interface material, preferably through a sheet (53) of thermal interface material.

5. The liquid cooling power flow control system of any of the preceding claims, wherein the at least one subsystem further comprises non-electrically conductive tubing for circulating the liquid coolant.

6. The liquid cooling power flow control system of any of the preceding claims, wherein the at least one switching assembly (9, 75) of the at least one subsystem is configured as a plurality of switching assemblies (9, 75), and wherein the plurality of switching assemblies (9, 75) are spaced apart and have insulating materials therebetween.

7. The liquid cooling power flow control system of any of the preceding claims, wherein the inlet port (41) of the liquid cooling block of the at least one subsystem comprises at least one aperture (43) to produce at least one jet of the liquid coolant.

8. The liquid cooling power flow control system of any of the preceding claims, wherein each of the at least one switching assembly (9, 75) of the at least one subsystem comprises a respective plurality of switches (4), and wherein a respective thermal path for the liquid coolant is arranged for each of the plurality of switching assemblies (9, 75).

9. The liquid cooling power control system according to any of the preceding claims, comprising a plurality of subsystems as described in any of claims 1 to 8,
wherein at least one of the subsystems further comprises a radiator (76) and/or a fan (77).

10. A method for liquid cooling in a power flow control system according to any of the preceding claims, comprising:
circulating liquid coolant by means of a pump (78) through a liquid cooling block (40), to each of at least one switching assembly (9, 75) each comprising a base plate (54);
arranging each of the at least one switching assembly (9, 75) within an enclosure (61) of the power flow control system, and electrically isolating each of the at least one switching assembly (9, 75) from the enclosure (61) of the power flow control system;
wherein preferably circulating the liquid coolant comprises circulating the liquid coolant through non-electrically conductive tubing.

11. The method of claim 10, wherein circulating the liquid coolant to the at least one switching assembly 9, 75) comprises impinging the liquid coolant directly onto the base plate (54) of at least one switching assembly (9, 75) and/or impinging the liquid coolant onto the respective cooling plate (51) that is thermally coupled to the base plate (54) of at least one switching assembly (9, 75).

12. The method of claims 10 or 11, wherein the at least one switching assembly (9, 75) is configured as a plurality of switching assemblies (9, 75), and the method further comprises:
connecting the plurality of switching 9, 75) assemblies in series or parallel to each other; and
injecting reactive power or reactive impedance into a power transmission line (5).

13. The method of any of claims 10 to 12, wherein circulating liquid coolant to at least one switching assembly (9, 75) comprises:
circulating the liquid coolant to raised areas (45, 52) of a respective cooling plate (51) that is thermally coupled to the base plate (54) of a respective switching assembly (9, 75); and/or
circulating the liquid coolant to a respective cooling plate (51) coupled through thermal interface material to the base plate (54).

14. The method of any of claims 10 to 14, wherein circulating the liquid coolant to the at least one switching assembly (9, 75) comprises producing jets of the liquid coolant that impinge onto the base plate (54) or onto a cooling plate (51) coupled to the base plate (54), of each switching assembly (9, 75).

## Patentansprüche

1. Flüssigkeitskühlungs-Leistungsflusssteuerungssystem, das in Reihe an eine Leistungsübertragungsleitung (5) anschließbar ist, wobei das System ein Gehäuse (61) und eine Vielzahl von Untersystemen umfasst, Folgendes umfassend;
einen Flüssigkeitskühlblock (40), umfassend ein flüssiges Kühlmittel, einen Einlassanschluss (41) für das flüssige Kühlmittel und einen Auslassanschluss (42) für das flüssige Kühlmittel;
eine Pumpe (78), die dazu konfiguriert ist, das flüssige Kühlmittel durch den Flüssigkeitskühlblock (40) umzuwälzen; und
mindestens eine Schaltbaugruppe (9, 75), die an eine Leistungsübertragungsleitung (5) anschließbar und dazu konfiguriert ist, eine Blindleistung oder eine Blindimpedanz in die Leistungsübertragungsleitung (5) zur Leistungsflusssteuerung der Leistungsübertragungsleitung (5) einzuspeisen;
wobei jede der mindestens einen Schaltbaugruppe innerhalb des Gehäuses (61) enthalten und von diesem elektrisch isoliert ist;
wobei jede der mindestens einen Schaltbaugruppe (9, 75) eine Basisplatte (54) umfasst, die angeordnet ist, um thermisch mit dem flüssigen Kühlmittel von einem von dem mindestens einen Flüssigkeitskühlblock (40) gekoppelt zu sein;
wobei mindestens eine Schaltbaugruppe (9, 75) ferner eine Kühlplatte (51) umfasst, die thermisch mit der jeweiligen Basisplatte (54) der jeweiligen Schaltbaugruppe (9, 75) gekoppelt ist;
wobei jede vom Gehäuse (61) elektrisch isolierte Schaltbaugruppe (9, 75) dazu konfiguriert ist, einer Isolationsspannung von mindestens 4000 V standzuhalten, vorzugsweise, einer Isolationsspannung von mindestens 6000 V standzuhalten;
wobei mindestens ein Paar der Vielzahl von Untersystemen parallel untereinander angeschlossen ist, wobei mindestens eine Dualeinheit gebildet wird, wobei jedes eine Dualeinheit bildende Untersystem jeweils als ein Leistungsflusssteuerungsmodul konfiguriert ist, das einen Gleichstromkondensator umfasst, der an die jeweilige mindestens eine Schaltbaugruppe (9, 75) des jeweiligen Untersystems angeschlossen ist;
wobei die eine oder die mehreren Dualeinheiten untereinander in Reihe angeschlossen sind; und
wobei die eine oder die mehreren Dualeinheiten an andere Untersysteme der Vielzahl von Untersystemen in Reihe angeschlossen sind.

2. Flüssigkeitskühlungs-Leistungsflusssteuerungssystem nach Anspruch 1,
wobei der Flüssigkeitskühlblock (40) des mindestens einen Untersystems dazu konfiguriert ist, dass die Flüssigkeitskühlung auf die jeweilige Basisplatte (54) mindestens einer Schaltbaugruppe (9, 75) und/oder auf die jeweilige Kühlplatte (51), die mit einer Basisplatte (54) mindestens einer Schaltbaugruppe (9, 75) thermisch gekoppelt ist, auftrifft.

3. Flüssigkeitskühlungs-Leistungsflusssteuerungssystem nach Anspruch 1 oder 2,
wobei jede der mindestens einen Schaltbaugruppe (9, 75) des mindestens einen Untersystems dazu konfigurierbar ist, einen Wechselstromausgang zur Einspeisung von Blindleistung oder Blindimpedanz in eine Leistungsübertragungsleitung (5) zu erzeugen; und/oder
wobei die mindestens eine Schaltbaugruppe (9, 75) des mindestens einen Untersystems als eine Vielzahl von Schaltbaugruppen (9, 75) konfiguriert ist, die zur Einspeisung von Blindleistung oder Blindimpedanz in die Leistungsübertragungsleitung (5) in Reihe oder parallel untereinander anschließbar sind.

4. Flüssigkeitskühlungs-Leistungsflusssteuerungssystem nach einem der vorhergehenden Ansprüche,
wobei die Kühlplatte (51) mindestens einer Schaltbaugruppe (9, 75) des mindestens einen Untersystems erhöhte Bereiche (45, 52) aufweist, die eine dreidimensionale Oberfläche definieren; und/oder
wobei die Kühlplatte (51) mindestens einer Schaltbaugruppe (9, 75) des mindestens einen Untersystems mit der jeweiligen Basisplatte (54) über ein thermisches Schnittstellenmaterial, vorzugsweise über eine Lage (53) aus thermischem Schnittstellenmaterial, thermisch gekoppelt ist.

5. Flüssigkeitskühlungs-Leistungsflusssteuerungssystem nach einem der vorhergehenden Ansprüche, wobei das mindestens eine Untersystem ferner nicht elektrisch leitende Rohre zur Umwälzung des flüssigen Kühlmittels umfasst.

6. Flüssigkeitskühlungs-Leistungsflusssteuerungssystem nach einem der vorhergehenden Ansprüche, wobei die mindestens eine Schaltbaugruppe (9, 75) des mindestens einen Untersystems als eine Vielzahl von Schaltbaugruppen (9, 75) konfiguriert ist, und wobei die Vielzahl von Schaltbaugruppen (9, 75) voneinander beabstandet sind und isolierende Materialien dazwischen aufweisen.

7. Flüssigkeitskühlungs-Leistungsflusssteuerungssystem nach einem der vorhergehenden Ansprüche, wobei der Einlassanschluss (41) des Flüssigkeitskühlblocks des mindestens einen Untersystems mindestens eine Öffnung (43) umfasst, um mindestens einen Strahl des flüssigen Kühlmittels zu erzeugen.

8. Flüssigkeitskühlungs-Leistungsflusssteuerungssystem nach einem der vorhergehenden Ansprüche, wobei jede der mindestens einen Schaltbaugruppe (9, 75) des mindestens einen Untersystems eine entsprechende Vielzahl von Schaltern (4) umfasst, und wobei für jede der Vielzahl von Schaltbaugruppen (9, 75) ein jeweiliger thermischer Pfad für das flüssige Kühlmittel angeordnet ist.

9. Flüssigkeitskühlungs-Leistungssteuerungssystem nach einem der vorhergehenden Ansprüche, umfassend eine Vielzahl von Untersystemen nach einem der Ansprüche 1 bis 8,
wobei mindestens eines der Untersysteme ferner einen Kühler (76) und/oder ein Gebläse (77) umfasst.

10. Verfahren zur Flüssigkeitskühlung in einem Leistungsflusssteuerungssystem nach einem der vorhergehenden Ansprüche, umfassend:
Umwälzen von flüssigem Kühlmittel mittels einer Pumpe (78) durch einen Flüssigkeitskühlblock (40) zu jeder von mindestens einer Schaltbaugruppe (9, 75), jeweils umfassend eine Basisplatte (54);
Anordnen jeder der mindestens einen Schaltbaugruppe (9, 75) innerhalb eines Gehäuses (61) des Leistungsflusssteuerungssystems und elektrisches Isolieren jeder der mindestens einen Schaltbaugruppe (9, 75) von dem Gehäuse (61) des Leistungsflusssteuerungssystems;
wobei das Umwälzen des flüssigen Kühlmittels vorzugsweise das Umwälzen des flüssigen Kühlmittels durch nicht elektrisch leitende Rohre umfasst.

11. Verfahren nach Anspruch 10, wobei das Umwälzen des flüssigen Kühlmittels zu der mindestens einen Schaltbaugruppe (9, 75) das Auftreffen des flüssigen Kühlmittels unmittelbar auf die Basisplatte (54) der mindestens einen Schaltbaugruppe (9, 75) und/oder das Auftreffen des flüssigen Kühlmittels auf die jeweilige Kühlplatte (51) umfasst, die thermisch mit der Basisplatte (54) der mindestens einen Schaltbaugruppe (9, 75) gekoppelt ist.

12. Verfahren nach Anspruch 10 oder 11, wobei die mindestens eine Schaltbaugruppe (9, 75) als eine Vielzahl von Schaltbaugruppen (9, 75) konfiguriert ist, und das Verfahren ferner Folgendes umfasst:
Anschließen der Vielzahl von Schaltbaugruppen (9, 75) in Reihe oder parallel untereinander; und
Einspeisen von Blindleistung oder Blindimpedanz in eine Leistungsübertragungsleitung (5).

13. Verfahren nach einem der Ansprüche 10 bis 12, wobei das Umwälzen von flüssigem Kühlmittel zu mindestens einer Schaltbaugruppe (9, 75) Folgendes umfasst:
Umwälzen des flüssigen Kühlmittels zu erhöhten Bereichen (45, 52) einer jeweiligen Kühlplatte (51), die thermisch mit der Basisplatte (54) einer jeweiligen Schaltbaugruppe (9, 75) gekoppelt ist; und/oder
Umwälzen des flüssigen Kühlmittels zu einer jeweiligen Kühlplatte (51), die durch thermisches Schnittstellenmaterial mit der Basisplatte (54) gekoppelt ist.

14. Verfahren nach einem der Ansprüche 10 bis 14, wobei das Umwälzen des flüssigen Kühlmittels zu der mindestens einen Schaltbaugruppe (9, 75) das Erzeugen von Strahlen des flüssigen Kühlmittels umfasst, die auf die Basisplatte (54) oder auf eine mit der Basisplatte (54) gekoppelte Kühlplatte (51) jeder Schaltbaugruppe (9, 75) auftreffen.

## Revendications

1. Système de régulation de flux de puissance de refroidissement par liquide pouvant être relié en série à une ligne de transmission de puissance (5), le système comprenant une enceinte (61) et une pluralité de sous-systèmes comprenant ;
un bloc de refroidissement par liquide (40) comprenant un fluide de refroidissement liquide, un orifice d'entrée (41) pour le fluide de refroidissement liquide et un orifice de sortie (42) pour le fluide de refroidissement liquide ;
une pompe (78) conçue pour faire circuler le fluide de refroidissement liquide à travers le bloc de refroidissement par liquide 40) ; et
au moins un ensemble de commutation (9, 75) pouvant être relié à une ligne de transmission de puissance (5) et conçu pour injecter une puissance réactive ou une impédance réactive dans la ligne de transmission de puissance (5) pour une régulation de flux de puissance de la ligne de transmission de puissance (5) ;
dans lequel chacun de l'au moins un ensemble de commutation est contenu au sein et isolé électriquement de l'enceinte (61) ;
dans lequel chacun de l'au moins un ensemble de commutation (9, 75) comprend une plaque de base (54) agencée pour se coupler thermiquement au fluide de refroidissement liquide de l'un de l'au moins un bloc de refroidissement par liquide (40) ;
dans lequel au moins un ensemble de commutation (9, 75) comprend en outre une plaque de refroidissement (51) qui est couplée thermiquement à la plaque de base (54) respective de l'ensemble de commutation (9, 75) respectif ;
dans lequel chaque ensemble de commutation (9, 75) isolé électriquement de l'enceinte (61) est conçu pour résister à une tension d'isolement d'au moins 4 000 V, de préférence pour résister à une tension d'isolement d'au moins 6000 V ;
dans lequel au moins une paire de la pluralité de sous-systèmes sont reliés en parallèle l'un à l'autre formant au moins une unité double, dans lequel chaque sous-système formant une unité double est respectivement conçu comme un module de régulation de flux de puissance comprenant un condensateur CC relié à l'au moins un ensemble de commutation (9, 75) respectif du sous-système respectif ;
dans lequel les une ou plusieurs unités doubles sont reliées en série l'une à l'autre ; et
dans lequel les une ou plusieurs unités doubles sont reliées en série à d'autres sous-systèmes de la pluralité de sous-systèmes.

2. Système de régulation de flux de puissance de refroidissement par liquide selon la revendication 1,
dans lequel le bloc de refroidissement par liquide (40) de l'au moins un sous-système est conçu de telle sorte que le fluide de refroidissement liquide frappe sur la plaque de base (54) respective d'au moins un ensemble de commutation (9, 75) et/ou sur la plaque de refroidissement (51) respective qui est thermiquement couplée à une plaque de base (54) d'au moins un ensemble de commutation (9, 75).

3. Système de régulation de flux de puissance du refroidissement par liquide selon les revendications 1 ou 2,
dans lequel chacun de l'au moins un ensemble de commutation (9, 75) de l'au moins un sous-système peut être conçu pour produire une sortie CA pour injecter une puissance réactive ou une impédance réactive dans une ligne de transmission de puissance (5) ; et/ou
dans lequel l'au moins un ensemble de commutation (9, 75) de l'au moins un sous-système est conçu comme une pluralité d'ensembles de commutation (9, 75) qui peuvent être reliés en série ou en parallèle les uns aux autres pour injecter une puissance réactive ou une impédance réactive dans la ligne de transmission de puissance (5).

4. Système de régulation de flux de puissance du refroidissement par liquide selon l'une quelconque des revendications précédentes,
dans lequel la plaque de refroidissement (51) d'au moins un ensemble de commutation (9, 75) de l'au moins un sous-système a des zones surélevées (45, 52) définissant une surface tridimensionnelle ; et/ou
dans lequel la plaque de refroidissement (51) d'au moins un ensemble de commutation (9, 75) de l'au moins un sous-système est couplée thermiquement à la plaque de base (54) respective à travers un matériau d'interface thermique, de préférence à travers une feuille (53) de matériau d'interface thermique.

5. Système de régulation de flux de puissance du refroidissement par liquide selon l'une quelconque des revendications précédentes, dans lequel l'au moins un sous-système comprend en outre un tube non conducteur d'électricité pour faire circuler le fluide de refroidissement liquide.

6. Système de régulation de flux de puissance du refroidissement par liquide selon l'une quelconque des revendications précédentes, dans lequel l'au moins un ensemble de commutation (9, 75) de l'au moins un sous-système est conçu comme une pluralité d'ensembles de commutation (9, 75), et dans lequel la pluralité d'ensembles de commutation (9, 75) sont espacés l'un de l'autre et ont des matériaux isolants entre eux.

7. Système de régulation de flux de puissance du refroidissement par liquide selon l'une quelconque des revendications précédentes, dans lequel l'orifice d'entrée (41) du bloc de refroidissement par liquide de l'au moins un sous-système comprend au moins une ouverture (43) pour produire au moins un jet de fluide de refroidissement liquide.

8. Système de régulation de flux de puissance du refroidissement par liquide selon l'une quelconque des revendications précédentes, dans lequel chacun de l'au moins un ensemble de commutation (9, 75) de l'au moins un sous-système comprend une pluralité respective de commutateurs (4), et dans lequel un chemin thermique respectif pour le fluide de refroidissement liquide est agencé pour chacun de la pluralité d'ensembles de commutation (9, 75).

9. Système de régulation de puissance de refroidissement par liquide selon l'une quelconque des revendications précédentes, comprenant une pluralité de sous-systèmes tels que décrits dans l'une quelconque des revendications 1 à 8,
dans lequel au moins un des sous-systèmes comprend en outre un radiateur (76) et/ou un ventilateur (77).

10. Procédé de refroidissement par liquide dans un système de régulation de flux de puissance selon l'une quelconque des revendications précédentes, comprenant :
la circulation d'un fluide de refroidissement liquide par le biais d'une pompe (78) à travers un bloc de refroidissement par liquide (40), vers chacun d'au moins un ensemble de commutation (9, 75) comprenant chacun une plaque de base (54) ;
l'agencement de chacun de l'au moins un ensemble de commutation (9, 75) au sein d'une enceinte (61) du système de régulation de flux de puissance, et l'isolement électrique de chacun de l'au moins un ensemble de commutation (9, 75) de l'enceinte (61) du système de régulation de flux de puissance ;
dans lequel, de préférence, la circulation du fluide de refroidissement liquide comprend la circulation du fluide de refroidissement liquide à travers des tubes non conducteurs d'électricité.

11. Procédé selon la revendication 10, dans lequel la circulation du fluide de refroidissement liquide vers l'au moins un ensemble de commutation (9, 75) comprend la frappe du fluide de refroidissement liquide directement sur la plaque de base (54) d'au moins un ensemble de commutation (9, 75) et/ou la frappe du fluide de refroidissement liquide sur la plaque de refroidissement (51) respective qui est couplée thermiquement à la plaque de base (54) d'au moins un ensemble de commutation (9, 75).

12. Procédé selon les revendications 10 ou 11, dans lequel l'au moins un ensemble de commutation (9, 75) est conçu comme une pluralité d'ensembles de commutation (9, 75), et le procédé comprend en outre :
la liaison de la pluralité d'ensembles de commutation 9, 75) en série ou en parallèle les uns aux autres ; et
l'injection de puissance réactive ou d'impédance réactive dans une ligne de transmission de puissance (5).

13. Procédé selon l'une quelconque des revendications 10 à 12, dans lequel la circulation de fluide de refroidissement liquide vers au moins un ensemble de commutation (9, 75) comprend :
la circulation du fluide de refroidissement liquide vers des zones surélevées (45, 52) d'une plaque de refroidissement (51) respective qui est thermiquement couplée à la plaque de base (54) d'un ensemble de commutation (9, 75) respectif ; et/ou
la circulation du fluide de refroidissement liquide vers une plaque de refroidissement (51) respective couplée à travers un matériau d'interface thermique à la plaque de base (54).

14. Procédé selon l'une quelconque des revendications 10 à 14, dans lequel la circulation du fluide de refroidissement liquide vers l'au moins un ensemble de commutation (9, 75) comprend la production de jets de fluide de refroidissement liquide qui frappent sur la plaque de base (54) ou une plaque de refroidissement (51) couplée à la plaque de base (54), de chaque ensemble de commutation (9, 75).
